(19) Europäisches Patentamt
European Patent Office
Office européen des brevets

(11) **EP 2 664 068 B1**

(12) **EUROPÄISCHE PATENTSCHRIFT**

(45) Veröffentlichungstag und Bekanntmachung des Hinweises auf die Patenterteilung:
**05.08.2015 Patentblatt 2015/32**

(51) Int Cl.:
*H03L 7/185* *(2006.01)*     *H03L 7/07* *(2006.01)*

(21) Anmeldenummer: **11794488.4**

(22) Anmeldetag: **13.12.2011**

(86) Internationale Anmeldenummer:
**PCT/EP2011/072566**

(87) Internationale Veröffentlichungsnummer:
**WO 2012/095230 (19.07.2012 Gazette 2012/29)**

(54) **HOCHFREQUENZGENERATOR MIT GERINGEM PHASENRAUSCHEN**

HIGH-FREQUENCY GENERATOR WITH LOW PHASE NOISE

GÉNÉRATEUR DE HAUTES FRÉQUENCES PRÉSENTANT UN FAIBLE BRUIT DE PHASE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.01.2011 DE 102011008350**

(43) Veröffentlichungstag der Anmeldung:
**20.11.2013 Patentblatt 2013/47**

(73) Patentinhaber: **Rohde & Schwarz GmbH & Co. KG 81671 München (DE)**

(72) Erfinder: **ROTH, Alexander 84405 Dorfen (DE)**

(74) Vertreter: **Körfer, Thomas Mitscherlich PartmbB Patent- und Rechtsanwälte Sonnenstrasse 33 80331 München (DE)**

(56) Entgegenhaltungen:
**DE-A1- 1 441 883     US-A1- 2009 309 665
US-A1- 2010 073 095**

**Beschreibung**

Die Erfindung betrifft einen Hochfrequenzsignalgenerator.

Bei herkömmlichen Signalgeneratoren wird ein in seiner Frequenz veränderliches Referenzsignal einem phasengeregelten Oszillator zugeführt. Dieser wird hierdurch zur Oszillation mit einer einstellbaren Frequenz angeregt.

So zeigt die DE 41 05 566 A1 einen Mischer, welcher einen Oszillator im GHz-Bereich auf eine saubere Frequenz synchronisiert. Dieser Mischer arbeitet mit einer Vervielfacherdiode, welche aus der Referenzfrequenz einen kurzen Puls erzeugt, mit dessen Linienspektrum das Signal des Oszillators abgemischt wird. Nachteilhaft bei diesem Verfahren ist der schlechte Signal-zu-Rausch-Abstand, der mit dieser Anordnung erreicht werden kann. Da der Samplingmischer auf allen Oberwellen des Referenzsignals umsetzt, wird auch sehr viel Rauschen in die Zwischenfrequenz gemischt. Dies schränkt die Empfindlichkeit ein.

Weiterhin zeigt die US 2009/0309665 A1 einen Hochfrequenzgenerator, welcher eine umschaltbare Phasenregelschleife beinhaltet. So wird das Ausgangssignal des Oszillators wahlweise einem Frequenzteiler oder einer Hintereinanderschaltung mehrerer Mischer zugeführt. Um den Oszillator auf eine Grobfrequenz einzustellen, wird das Signal des Frequenzteilers herangezogen. Um anschließend die Feineinstellung durchzuführen, wird auf das Signal der hintereinandergeschalteten Mischer umgeschaltet. Auch mit einem Signalgenerator nach diesem Konzept kann lediglich suboptimales Phasenrauschen erreicht werden.

Der Erfindung liegt die Aufgabe zugrunde, einen Hochfrequenz-Signalgenerator zu schaffen, welcher bei geringem Phasenrauschen einen sehr guten Nebenlinienabstand ermöglicht.

Die Aufgabe wird erfindungsgemäß durch die Merkmale des unabhängigen Anspruchs 1 gelöst. Vorteilhafte Weiterbildungen sind Gegenstand der hierauf rückbezogenen Unteransprüche.

Der erfindungsgemäße Oszillator verfügt vorzugsweise über zwei mittels Phasenregelschleifen geregelte Oszillatoren. Eine erste Phasenregelschleife erzeugt dabei eine qualitativ hochwertige Referenzfrequenz, welche in kleinen diskreten Schritten über ca. 10% der Frequenz verstimmt werden kann. Durch den eingeschränkten Frequenzbereich lassen sich hierfür sehr gute spannungsgesteuerte Oszillatoren konstruieren. Durch die bevorzugte Verwendung eines Frequenzteilers außerhalb der Phasenregelschleife bleibt das Phasenrauschen eines ursprünglichen frequenzfesten Referenzsignals weitgehend erhalten. Die Vergleichsfrequenz liegt vorteilhafterweise bei > 10 MHz, sodass schnelle Frequenzwechsel möglich sind. Passive Verdopplerstufen mit anschließender Filterung werden bevorzugt eingesetzt, um einen extrem rauscharmen Betrieb zu realisieren. Durch die vorteilhaften Filter zwischen den Verdopplerstufen werden unerwünschte Oberwellen unterdrückt.

Um das Abmischen des spannungsgesteuerten Oszillators auf der Ausgangsfrequenz mit verschiedenen Oberwellen der Referenzfrequenz zu ermöglichen, werden in einer weiteren Schaltung in Kette geschaltete überbrückbare Mischer verwendet. Das Ausgangssignal des Oszillators kann je nach Stellung der Überbrückungsschalter mit den verschiedenen Referenzsignalen abgemischt werden. Durch Verwendung des Spiegelsignals des ersten Mischers kann dieser Frequenzbereich weiter erhöht werden. Die entstehende Zwischenfrequenz wird bevorzugt mit einem digitalen Phasendetektor auf einen Bruchteil der Referenzfrequenz synchronisiert.

Durch die bevorzugte Verwendung des Referenzsignals als Eingangssignal für den Teiler wird erreicht, dass keine kreuzenden Mischprodukte in den Mischern entstehen. Die Mischprodukte liegen vorteilhafterweise auf einem Raster, welches der letzten Zwischenfrequenz geteilt durch die Auflösung des Teilers entspricht. Durch geeignete Wahl der Teilerfaktoren können diese Mischprodukte so gewählt werden, dass diese Mischprodukte durch das Schleifenfilter unterdrückt werden und somit keine Nebenlinien im Synthesizer entstehen.

Um einen sehr schnellen Frequenzwechsel zu ermöglichen, wird vorteilhafterweise der Oszillator vorabgestimmt. Die Abstimmung beruht auf einer individuell gemessenen Kennlinie des Oszillators.

Der erfindungsgemäße Hochfrequenzoszillator verfügt über einen Referenzfrequenzgenerator und einem Hochfrequenzgenerator. Der Referenzfrequenzgenerator erzeugt eine variable Referenzfrequenz und führt sie dem Hochfrequenzgenerator zu. Der Hochfrequenzgenerator verfügt über eine Phasenregelschleife und erzeugt aus der variablen Referenzfrequenz ein Hochfrequenzsignal. Die Phasenregelschleife verfügt über zumindest einen ersten Mischer, einen zweiten Mischer und über mehrere Schalter. Der erste Mischer, der zweite Mischer und die Schalter sind in Serie geschaltet. Die Mischer sind mittels der Schalter einzeln selektiv in die Phasenregelschleife geschaltet. Es wird so eine Einstellbarkeit der Ausgangsfrequenz bei sehr geringem Phasenrauschen erreicht.

Durch Tiefpassfilter nach jedem Mischer kann das Phasenrauschen weiter verringert werden.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:

Fig. 1    eine erste Teilansicht eines Blockschaltbilds eines Ausführungsbeispiels des erfindungsgemäßen Oszillators, und

Fig. 2    eine zweite Teilansicht des Blockschaltbilds des Ausführungsbeispiels des erfindungsgemäßen Oszillators.

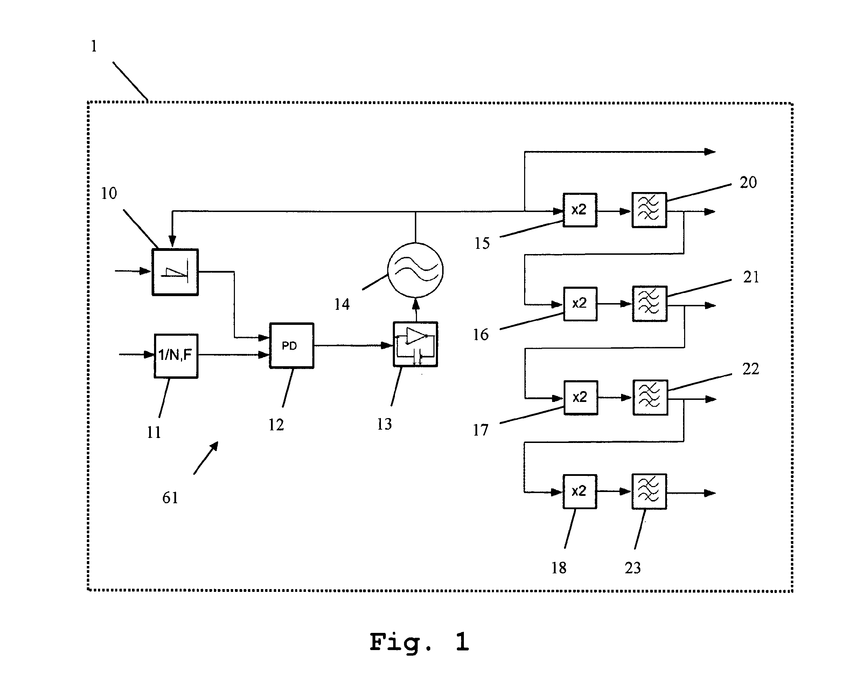

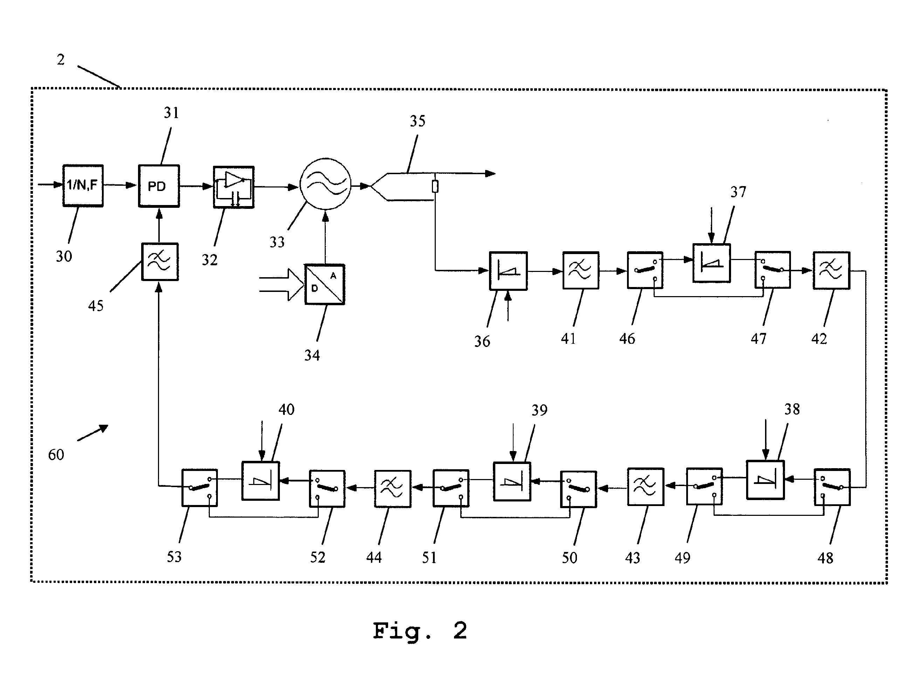

Zunächst wird anhand der Fig. 1 der Aufbau und die Funktionsweise eines Referenzfrequenzgenerators erläutert. Anschließend wird anhand von Fig. 2 die Funktion eines Hochfrequenzgenerators gezeigt. Identische Elemente wurden in ähnlichen Abbildungen zum Teil nicht wiederholt dargestellt und beschrieben.

In Fig. 1 und Fig. 2 ist in zwei verschiedenen Ansichten ein Ausführungsbeispiel des erfindungsgemäßen Hochfrequenzoszillators dargestellt. Ein Referenzfrequenzgenerator 1 beinhaltet einen fraktionalen Frequenzteiler 11, einen Phasendetektor 12, ein Schleifenfilter 13, einen spannungsgesteuerten Oszillator 14 und einen Mischer 10. Dem fraktionalen Frequenzteiler 11 wird ein frequenzstabiles Referenzsignal von z.B. 640MHz zugeführt. Der fraktionale Frequenzteiler 11 erzeugt ein Signal mit einer durch $N_{Fref}$ geteilten Frequenz und führt es dem Phasendetektor 12 zu. Der Phasendetektor 12 vergleicht dieses Signal mit einem von dem Mischer 10 erzeugten Signal und gibt ein entsprechendes Ausgangssignal an das Schleifenfilter 13 aus. Dieses filtert das Signal und überträgt es an den spannungsgesteuerten Oszillator 14. Dieser erzeugt ein Ausgangssignal von beispielsweise 650MHz-700MHz und führt es erneut dem Mischer 10 zu. Dieser mischt dieses Ausgangssignal mit dem frequenzstabilen Referenzsignal.

Bei einem Referenzsignal von beispielsweise 640 MHz ergibt sich ein Ausgangssignal des Mischers von 10MHz-60MHz. Die Frequenz des Ausgangssignals des spannungsgesteuerten Oszillators 14 wird somit durch Einstellung des Teilungsfaktors $N_{Fref}$ des fraktionalen Teilers 11 eingestellt.

Der Referenzfrequenzgenerator 1 verfügt weiterhin über mehrere Frequenzverdoppler 15, 16, 17, 18, welche die Frequenz eines angelegten Signals verdoppeln. Jedem Frequenzverdoppler 15 - 18 ist ein Bandpassfilter 20 - 23 nachgeschaltet, welche lediglich jeweils die verdoppelte Frequenz passieren lassen und übrige Komponenten der Signale herausfiltern. Am Ausgang des spannungsgesteuerten Oszillators 14 liegt somit ein Referenzfrequenzsignal von im Beispiel 650MHz-700MHz an. Am Ausgang des Bandpassfilters 20 liegt somit eine doppelte Referenzfrequenz von 1,3-1,4 GHz an. Am Ausgang des Bandpassfilters 21 liegt eine 4-fache Referenzfrequenz von 2,6-2,8 GHz an. Am Ausgang des Bandfilters 22 liegt eine 8-fache Referenzfrequenz von 5,2-5,6 GHz an. Am Ausgang des Bandpassfilters 23 liegt eine 16-fache Referenzfrequenz von 10,4-11,2 GHz an.

Die 2-fache Referenzfrequenz von 1,3-1,4 GHz wird einem fraktionalen Frequenzteiler 30 des Hochfrequenzgenerators 2 zugeführt. Dieser teilt die Frequenz des Signals durch einen Teilungsfaktor von $N_{Fmain}$. Durch die niedrige Zwischenfrequenz zur Synchronisation wird eine hohe Qualität, d.h. ein sehr geringes Phasenrauschen erreicht. Durch ein Vervielfachen der Frequenz des Referenzsignals in kleinen Schritten und jeweils anschließender Filterung, wird ein sehr geringes Phasenrauschen der Referenzfrequenz erreicht.

Das Ausgangssignal des fraktionalen Frequenzteilers 30 wird einem Phasendiskriminator 31 zugeführt, welcher es mit dem Signal einer Phasenregelschleife 60 vergleicht und ein entsprechendes Ausgangssignal an einen Schleifenfilter 32 weiterleitet. Dieser filtert das Signal und gibt es an einen spannungsgesteuerten oder stromgesteuerten Oszillator 33, vorteilhafterweise einen Yttrium-Eisen-Granat (YIG)-Oszillator weiter. Das Signal des Schleifenfilters 32 dient zur Feineinstellung der Frequenz des gesteuerten Oszillators 33.

Dem gesteuerten Oszillator 33 wird weiterhin von einer Grob-Steuereinrichtung 34 ein Signal zur Grobeinstellung seiner Ausgangsfrequenz zugeführt.

Das Ausgangssignal des spannungsgesteuerten Oszillators 33 wird über einen Signalteiler 35 der Phasenregelschleife 60 zugeführt. Es durchläuft zunächst einen Mischer 36, von welchem es mit der 16-fachen Referenzfrequenz gemischt wird. Das Ausgangssignal des Mischers wird einem Tiefpassfilter 41 zugeführt, welcher lediglich das untere Mischprodukt passieren lässt. Das Ausgangssignal wird einem Schalter 46 zugeführt, welcher es wahlweise einem weiteren Mischer 37 zuführt oder diesen Mischer 37 überbrückt. Wird das Signal dem Mischer 37 zugeführt, wird es mit der 8-fachen Referenzfrequenz von im Beispiel 5,2-5,6GHz gemischt. Mit dem Ausgang des Mischers 37 ist ein weiterer Schalter 47 verbunden, welcher zusammen mit dem Schalter 46 die Aufschaltung des Mischers 37 oder seine Überbrückung durchführt.

Das resultierende Signal wird einem weiteren Bandpassfilter 42 zugeführt, welcher lediglich das untere Mischprodukt des Mischers 37 passieren lässt. Falls der Mischer 37 überbrückt wurde, spielt der Tiefpassfilter 42 für das anliegende Signal keine Rolle. Das Ausgangssignal wird erneut einer Kombination von zwei Schaltern 48, 49 zugeführt, welche wie auch die Schalter 46, 47 das Signal entweder einen weiteren Mischer 38 zuführen oder diesen überbrücken. Wird das Signal dem weiteren Mischer 38 zugeführt, so mischt dieser es mit der vierfachen Referenzfrequenz von im Beispiel 2,6-2,8 GHz. Das Ausgangssignal wird erneut einem Tiefpassfilter 43 zugeführt, welcher ebenfalls lediglich das untere Mischprodukt passieren lässt. Auch hier spielt der Filter 43 keine Rolle, falls der Mischer 38 überbrückt wurde.

Weitere Schalter 50, 51, ein weiterer Mischer 39 und ein weiterer Tiefpassfilter 44 bilden eine weitere entsprechende Funktionseinheit. Der weitere Mischer 39 mischt mit der doppelten Referenzfrequenz von im Beispiel 1,3-1,4 GHz.

Weitere Schalter 52, 53, ein weiterer Mischer 40 und ein weiterer Tiefpassfilter 45 bilden eine erneute entsprechende Funktionseinheit. Der weitere Mischer 40 mischt mit der unveränderten Referenzfrequenz von im Beispiel 650-700 MHz. Das resultierende Signal nach dem Tiefpassfilter 45 wird dem Phasendiskriminator 31 zugeführt.

Die Signale, mit welchen die Mischer 36 - 40 das Signal der Phasenregelschleife 60 mischen, werden dem Referenzfrequenzgenerator 1 entnommen. Vorteilhafterweise kann auch der ersten Mischer 36 mit Schaltern versehen sein. In diesem Fall kann auch dieser Mischer überbrückt werden. Alternativ kann auch eine höhere oder geringere Anzahl von Mischern in der Phasenregelschleife eingesetzt werden. Je höher der Abstimmbereich des Oszillators sein soll, desto mehr Mischer werden eingesetzt.

Die Phasenregelschleife 60 beinhaltet somit die Mischer 36 - 40, die Bandpassfilter 41 - 45, die Schalter 46 - 53, den Phasendiskriminator 31 und den Schleifenfilter 32.

Im Folgenden wird erläutert, wie die Teilungsfaktoren $N_{Fref}$ und $N_{Fmain}$ der fraktionalen Teiler 11, 30, eingestellt werden, um eine gewünschte Ausgangsfrequenz des Oszillators zu erreichen.

Ausgegangen wird von einer Ausgangsfrequenz des Oszillators von beispielsweise 10000 MHz bis 18000 MHz. Zunächst wird der Parameter V, welcher dem Vielfachen der Referenzfrequenz $f_{ref}$, mit der abgemischt werden soll, entspricht, berechnet. Als Grundlage dienen die minimal einstellbare Referenzfrequenz von im Beispiel 650 MHz und eine für die Hauptschleife günstige Zwischenfrequenz von z.B. 55 MHz.

$$V = INT ((f_{osz} + 55\ MHz) / 650\ MHz)$$

Anschließend wird die Referenzfrequenz $f_{ref}$ berechnet. Hierzu wird das zuvor bestimmte V herangezogen. Da V auf ganze Zahlen abgerundet wird, ergibt sich eine Referenzfrequenz, welche etwas höher als 650 MHz liegt.

$$f_{ref} = (f_{osz} + 55\ MHz) / V$$

Nun wird der Wert des Teilers 11 des Referenzfrequenzgenerators berechnet. Der Teilfaktor $N_{Fref}$ des Referenzfrequenzgenerators 1 wird so gerundet, dass keine Nebenlinien innerhalb der Schleifenbandbreite auftreten.

$$N_{Fref} = 640\ MHz / ABS[(640\ MHz - f_{ref})]\ ,$$

mit runden auf 1/F mit

$$F = 8\ für\ N < 20$$

$$F = 4\ für\ 20 <= N < 40$$

$$F = 2\ für\ 40 <= N < 80$$

$$F = 1\ für\ 80 <= N$$

Durch das Runden auf verschiedene 1/F wird verhindert, dass die Modulation durch einen Nachkommaanteil niedriger als 8 MHz wird und damit von der Phasenregelschleife gedämpft werden kann.

Anschließend wird die Zwischenfrequenz $f_{zf}$ in der Phasenregelschleife 60 des Hochfrequenzgenerators 2 berechnet. Durch das Runden des Teilers 30 bei der Erzeugung der Referenzfrequenz $f_{ref}$ ergibt sich eine Zwischenfrequenz $F_{zf}$, welche von dem Sollwert abweicht.

$$f_{zf} = V * 640\ MHz * (1 - 1 / N_{Fref}) - f_{osz}$$

Diese errechnete Zwischenfrequenz $f_{zf}$ wird nun auf einen einstellbaren Wert gerundet.

$$N_{Fmain} = 2 * 640 \text{ MHz} * (1 - 1 / N_{Fref}) / f_{zf}$$

mit runden des Teilfaktors auf 1/F mit

$$F = 16 \text{ für } N < 10$$

$$F = 8 \text{ für } 10 <= N < 20$$

$$F = 4 \text{ für } 20 <= N < 40$$

$$F = 2 \text{ für } 40 <= N < 80$$

$$F = 1 \text{ für } 80 <= N$$

Durch das Runden auf verschiedene 1/F wird verhindert, dass die Modulation durch den Nachkommaanteil niedriger als etwa 8 MHz wird. Die dadurch entstehenden Nebenlinien werden dadurch von Phasenregelschleife 60 des Hochfrequenzgenerators 1 unterdrückt.

Abschließend wird die tatsächliche Frequenz $f_{osz}$ des spannungsgesteuerten Oszillators 33 des Hochfrequenzgenerators 2 berechnet.

$$f_{osz} = V * 640 \text{ MHz} * (1 - 1 / N_{Fref}) - (2 * 640 \text{ MHz} * (1 - 1/N_{Fref}) / N_{Fmain})$$

Der Restfehler, der durch das Runden der Teilfaktoren $N_{Fref}$, $N_{Fmain}$ entsteht, ist kleiner als 1 MHz und kann toleriert werden. Durch den vorteilhaften Einsatz eines direkten digitalen Synthesizers in der Phasenregelschleife 60 des Hochfrequenz-Oszillators 2 anstelle des fraktionalen Teilers 30 wäre eine beliebige Frequenzauflösung möglich.

Die Erfindung ist nicht auf das dargestellte Ausführungsbeispiel beschränkt. Alle vorstehend beschriebenen Merkmale oder in den Figuren gezeigten Merkmale sind im Rahmen der Erfindung beliebig vorteilhaft miteinander kombinierbar.

**Patentansprüche**

1. Hochfrequenzoszillator mit einem Referenzfrequenzgenerator (1) und einem Hochfrequenzgenerator (2),
   wobei der Referenzfrequenzgenerator (1) eine variable Referenzfrequenz ($f_{ref}$) erzeugt und zumindest mittelbar dem Hochfrequenzgenerator (2) zuführt,
   wobei der Hochfrequenzgenerator (2) über eine Phasenregelschleife (60) verfügt,
   wobei der Hochfrequenzgenerator (2) zumindest mittelbar aus der variablen Referenzfrequenz ($f_{ref}$) ein Hochfrequenzsignal ($f_{osz}$) erzeugt,
   wobei die Phasenregelschleife (60) über zumindest einen ersten Mischer (40) und einen zweiten Mischer (39) verfügt,
   **dadurch gekennzeichnet,**
   **dass** die Phasenregelschleife (60) weiterhin über Schalter (46, 47, 48, 49, 50, 51, 52, 53) verfügt,
   **dass** der erste Mischer (40), der zweite Mischer (39) und die Schalter (46, 47, 48, 49, 50, 51, 52, 53) in Serie geschaltet sind,
   **dass** die Mischer (39, 40) mittels der Schalter (46, 47, 48, 49, 50, 51, 52, 53) einzeln selektiv in die Phasenregelschleife (60) schaltbar sind,

**dass** die Phasenregelschleife (60) über ein Tiefpassfilter (41, 42, 43, 44, 45) nach jedem Mischer (36, 37, 38, 39, 40) verfügt,

**dass** der Referenzfrequenzgenerator (1) den Mischern (36, 37, 38, 39, 40) die variable Referenzfrequenz ($f_{ref}$) oder ein ganzzahliges Vielfaches der variablen Referenzfrequenz ($f_{ref}$) zuführt,

**dass** die Phasenregelschleife (60) weiterhin über einen Phasendiskriminator (31) verfügt, und

**dass** der Phasendiskriminator (31) ein von der Phasenregelschleife (60) erzeugtes Signal mit einem von der variablen Referenzfrequenz ($f_{ref}$) abgeleiteten Signal vergleicht.

2. Hochfrequenzoszillator nach Anspruch 1,
   **dadurch gekennzeichnet,**
   **dass** die Phasenregelschleife (60) über genau zwei Schalter (46, 47, 48, 49, 50, 51, 52, 53) pro Mischer (37, 38, 39, 40) außer bei einem Mischer (36) verfügt,
   **dass** die Schalter (46, 47, 48, 49, 50, 51, 52, 53) in einer ersten Schalterstellung den jeweiligen Mischer (37, 38, 39, 40) in die Phasenregelschleife (60) schalten, und dass die Schalter (46, 47, 48, 49, 50, 51, 52, 53) in einer zweiten Schalterstellung den jeweiligen Mischer (37, 38, 39, 40) überbrücken.

3. Hochfrequenzoszillator nach Anspruch 1 oder 2,
   **dadurch gekennzeichnet,**
   **dass** der Referenzfrequenzgenerator (1) dem ersten Mischer (40) die variable Referenzfrequenz ($f_{ref}$) und dem zweiten Mischer (39) die doppelte variable Referenzfrequenz ($f_{ref}$) zuführt.

4. Hochfrequenzoszillator nach einem der Ansprüche 1 bis 3,
   **dadurch gekennzeichnet,**
   **dass** die Phasenregelschleife (60) N Mischer (36, 37, 38, 39, 40) aufweist, und
   **dass** der Referenzfrequenzgenerator (1) den N Mischern (36, 37, 38, 39, 40) jeweils die $N^2$-fache variable Referenzfrequenz ($f_{ref}$) zuführt.

5. Hochfrequenzoszillator nach einem der Ansprüche 1 bis 4,
   **dadurch gekennzeichnet,**
   **dass** die Phasenregelschleife (60) N Mischer (36, 37, 38, 39, 40) aufweist,
   **dass** die Phasenregelschleife (60) für jeden der N Mischer (36, 37, 38, 39, 40) über einen Frequenzvervielfacher verfügt,
   **dass** der jeweilige Frequenzvervielfacher die variable Referenzfrequenz ($f_{ref}$) zu der $N^2$-fachen variablen Referenzfrequenz ($f_{ref}$) umsetzt und dem N-ten Mischer (36, 37, 38, 39, 40) zuführt.

6. Hochfrequenzoszillator nach einem der Ansprüche 1 bis 5,
   **dadurch gekennzeichnet,**
   **dass** die Schalter (46, 47, 48, 49, 50, 51, 52, 53) der Phasenregelschleife (60) derart ausgestaltet sind, dass stets zumindest ein Mischer (36, 37, 38, 39, 40), bevorzugt zumindest zwei Mischer (36, 37, 38, 39, 40), in die Phasenregelschleife (60) geschaltet sind.

7. Hochfrequenzoszillator nach einem der Ansprüche 1 bis 6,
   **dadurch gekennzeichnet,**
   **dass** der Hochfrequenzgenerator (2) weiterhin über einen spannungsgesteuerten oder stromgesteuerten Oszillator (33), bevorzugt einen Yttrium-Eisen-Granat (YIG)-Oszillator verfügt,
   **dass** die Phasenregelschleife (60) dem gesteuerten Oszillator (33) ein Fein-Steuersignal zuführt,
   **dass** der Hochfrequenzgenerator (2) weiterhin über eine Grob-Steuereinrichtung (34) verfügt, und
   **dass** die Grob-Steuereinrichtung (34) dem gesteuerten Oszillator (33) ein Grob-Steuersignal zuführt.

8. Hochfrequenzoszillator nach einem der Ansprüche 1 bis 7,
   **dadurch gekennzeichnet,**
   **dass** der Hochfrequenzgenerator (2) weiterhin über einen fraktionalen Teiler (30) verfügt, und
   **dass** der fraktionale Teiler (30) die Frequenz des Signals, das von der von dem, von dem Referenzfrequenzgenerator (1) erzeugten variablen Referenzfrequenz ($f_{ref}$) abgeleitet ist, mit einem Teilerfaktor ($N_{Fmain}$) teilt.

9. Hochfrequenzoszillator nach einem der Ansprüche 1 bis 8,
   **dadurch gekennzeichnet,**
   **dass** der Hochfrequenzgenerator (2) weiterhin über einen Leistungsteiler (35) verfügt, und

**dass** der Leistungsteiler (35) ein Teil des Hochfrequenzsignals ($f_{osz}$) des spannungsgesteuerten Oszillators (33) der Phasenregelschleife (60) zuführt.

10. Hochfrequenzoszillator nach einem der Ansprüche 1 bis 9,
**dadurch gekennzeichnet,**
**dass** der Referenzfrequenzgenerator (1) über einen mittels einer Phasenregelschleife (61) geregelten Oszillator (14) und einen Frequenzteiler (11) verfügt,
**dass** der Frequenzteiler (11) ein Referenzsignal fester Frequenz mit einem variablen Teilungsfaktor ($N_{Fref}$) teilt und der Phasenregelschleife (61) zuführt, und
**dass** die Frequenz des Hochfrequenzsignals ($f_{ref}$) des geregelten Oszillators (11) mittels des variablen Teilungsfaktors ($N_{Fref}$) einstellbar ist.

11. Hochfrequenzoszillator nach Anspruch 10,
**dadurch gekennzeichnet,**
**dass** der Referenzfrequenzgenerator (1) über zumindest zwei Frequenzverdoppler (15, 16, 17, 18) und zumindest zwei Bandpassfilter (20, 21, 22, 23) verfügt,
**dass** der geregelte Oszillator (14) mit einem ersten Frequenzverdoppler (15) verbunden ist,
**dass** ein erster Bandpassfilter (20) mit dem ersten Frequenzverdoppler (15) verbunden ist,
**dass** der erste Bandpassfilter (20) weiterhin mit einem zweiten Frequenzverdoppler (16) verbunden ist,
**dass** der zweite Frequenzverdoppler (16) mit einem zweiten Bandpassfilter (21) verbunden ist,
**dass** der erste Bandpassfilter (20) eine doppelte Referenzfrequenz ($2*f_{ref}$) ausgibt, und
**dass** der zweite Bandpassfilter (21) eine vierfache Referenzfrequenz ($4*f_{ref}$) ausgibt.

12. Hochfrequenzoszillator nach einem der Ansprüche 1 bis 11,
**dadurch gekennzeichnet,**
**dass** Referenzfrequenzgenerator (1) über N in Serie geschaltete Frequenzverdoppler (15, 16, 17, 18) und N zugehörige Bandpassfilter (20, 21, 22, 23) verfügt, und dass die N Bandpassfilter (20, 21, 22, 23) jeweils eine N-fache Referenzfrequenz ($N*f_{ref}$) ausgeben.

## Claims

1. High frequency oscillator with a
reference frequency generator (1) and a
high frequency generator (2),
wherein the reference frequency generator (1) produces a variable reference frequency ($f_{ref}$) and feeds it at least indirectly to the high frequency generator (2), wherein the high frequency generator (2) has a phase control loop (60), wherein the high frequency generator (2) produces a high frequency signal ($f_{osc}$) at least indirectly from the variable reference frequency ($f_{ref}$),
wherein the phase control loop (60) has at least a first mixer (40) and a second mixer (39),
**characterised in that**
the phase control loop (60) also has switches (46, 47, 48, 49, 50, 51, 52, 53),
**in that** the first mixer (40), the second mixer (39) and the switches (46, 47, 48, 49, 50, 51, 52, 53) are connected in series,
**in that** the mixers (39, 40) can be switched individually and selectively into the phase control loop (60) by means of the switches (46, 47, 48, 49, 50, 51, 52, 53),
**in that** the phase control loop (60) has a low-pass filter (41, 42, 43, 44, 45) after each mixer (36, 37, 38, 39, 40),
**in that** the reference frequency generator (1) feeds the variable reference frequency ($f_{ref}$) or an integral multiple of the variable reference frequency ($f_{ref}$) to the mixers (36, 37, 38, 39, 40),
**in that** the phase control loop (60) also has a phase discriminator (31), and
**in that** the phase discriminator (31) compares a signal produced by the phase control loop (60) with a signal derived from the variable reference frequency ($f_{ref}$).

2. High frequency oscillator according to claim 1,
**characterised in that** the phase control loop (60) has exactly two switches (46, 47, 48, 49, 50, 51, 52, 53) per mixer (37, 38, 39, 40) except in the case of a mixer (36),
**in that** the switches (46, 47, 48, 49, 50, 51, 52, 53) in a first switch position switch the respective mixer (37, 38, 39, 40) into the phase control loop (60), and

**in that** the switches (46, 47, 48, 49, 50, 51, 52, 53) in a second switch position bridge the respective mixer (37, 38, 39, 40).

3. High frequency oscillator according to claim 1 or 2,
    **characterised in that** the reference frequency generator (1) feeds the variable reference frequency ($f_{ref}$) to the first mixer (40) and double the variable reference frequency ($f_{ref}$) to the second mixer (39).

4. High frequency oscillator according to one of claims 1 to 3,
    **characterised in that** the phase control loop (60) exhibits N mixers (36, 37, 38, 39, 40), and
    **in that** the reference frequency generator (1) feeds $N^2$ times the variable reference frequency ($f_{ref}$) to the N mixers (36, 37, 38, 39, 40).

5. High frequency oscillator according to one of claims 1 to 4,
    **characterised in that** the phase control loop (60) exhibits N mixers (36, 37, 38, 39, 40),
    **in that** the phase control loop (60) has a frequency multiplier for each of the N mixers (36, 37, 38, 39, 40),
    **in that** the respective frequency multiplier converts the variable reference frequency ($f_{ref}$) to $N^2$ times the variable reference frequency ($f_{ref}$) and feeds it to the Nth mixer (36, 37, 38, 39, 40).

6. High frequency oscillator according to any of claims 1 to 5,
    **characterised in that** the switches (46, 47, 48, 49, 50, 51, 52, 53) of the phase control loop (60) are designed in such a way that at all times at least one mixer (36, 37, 38, 39, 40), preferably at least two mixers (36, 37, 38, 39, 40), are switched into the phase control loop (60).

7. High frequency oscillator according to one of claims 1 to 6,
    **characterised in that** the high frequency generator (2) also has a voltage-controlled or current-controlled oscillator (33), preferably an yttrium-iron-garnet (YIG) oscillator, **in that** the phase control loop (60) feeds a fine control signal to the controlled oscillator (33),
    **in that** the high frequency generator (2) also has a coarse control device (34), and
    **in that** the coarse control device (34) feeds a coarse control signal to the controlled oscillator (33).

8. High frequency oscillator according to one of claims 1 to 7,
    **characterised in that** the high frequency generator (2) also has a fractional divider (30), and
    **in that** the fractional divider (30) divides the frequency of the signal which is derived from the variable reference frequency ($f_{ref}$) produced by the reference frequency generator (1) with a divider factor ($N_{Fmain}$).

9. High frequency oscillator according to one of claims 1 to 8,
    **characterised in that** the high frequency generator (2) also has a power divider (35), and
    **in that** the power divider (35) feeds a part of the high frequency signal ($f_{osc}$) of the voltage-controlled oscillator (33) to the phase control loop (60).

10. High frequency oscillator according to one of claims 1 to 9,
    **characterised in that** the reference frequency generator (1) has an oscillator (14) controlled by means of a phase control loop (61), and a frequency divider (11),
    **in that** the frequency divider (11) divides a reference signal of fixed frequency with a variable division factor ($N_{Fref}$) and feeds it to the phase control loop (61), and
    **in that** the frequency of the high frequency signal ($f_{ref}$) of the controlled oscillator (14) can be set by means of the variable division factor ($N_{Fref}$).

11. High frequency oscillator according to claim 10,
    **characterised in that** the reference frequency generator (1) has at least two frequency doublers (15, 16, 17, 18) and at least two band-pass filters (20, 21, 22, 23),
    **in that** the controlled oscillator (14) is connected with a first frequency doubler (15), **in that** a first band-pass filter (20) is connected with the first frequency doubler (15), **in that** the first band-pass filter (20) is also connected with a second frequency doubler (16),
    **in that** the second frequency doubler (16) is connected with a second band-pass filter (21),
    **in that** the first band-pass filter (20) emits a doubled reference frequency ($2*f_{ref}$), and **in that** the second band-pass filter (21) emits a quadrupled reference frequency ($4*f_{ref}$).

**12.** High frequency oscillator according to one of claims 1 to 11,
**characterised in that** the reference frequency generator (1) has N frequency doublers (15, 16, 17, 18) connected in series and N associated band-pass filters (20, 21, 22, 23), and
**in that** the N band-pass filters (20, 21, 22, 23) each emit N times the reference frequency ($N*f_{ref}$).

**Revendications**

**1.** Oscillateur haute fréquence comportant un générateur de fréquence de référence (1) et un générateur haute fréquence (2),
dans lequel le générateur de fréquence de référence (1) génère une fréquence de référence variable ($f_{ref}$) et la délivre au moins indirectement au générateur haute fréquence (2),
dans lequel le générateur haute fréquence (2) comporte une boucle de verrouillage de phase (60),
dans lequel le générateur haute fréquence (2) génère un signal haute fréquence ($f_{osz}$) au moins indirectement à partir de la fréquence de référence variable ($f_{ref}$),
dans lequel la boucle de verrouillage de phase (60) comporte au moins un premier mélangeur (40) et un second mélangeur (39),
**caractérisé en ce que**
la boucle de verrouillage de phase (60) comporte en outre des commutateurs (46, 47, 48, 49, 50, 51, 52, 53),
**en ce que** le premier mélangeur (40), le second mélangeur (39) et les commutateurs (46, 47, 48, 49, 50, 51, 52, 53) sont montés en série,
**en ce que** les mélangeurs (39, 40) peuvent être montés individuellement sélectivement dans la boucle de verrouillage de phase (60) grâce aux commutateurs (46, 47, 48, 49, 50, 51, 52, 53),
**en ce que** la boucle de verrouillage de phase (60) comporte un filtre passe bas (41, 42, 43, 44, 45) après chaque mélangeur (36, 37, 38, 39, 40),
**en ce que** le générateur de fréquence de référence (1) délivre aux mélangeurs (36, 37, 38, 39, 40) la fréquence de référence variable ($f_{ref}$) ou un multiple entier de la fréquence de référence variables ($f_{ref}$),
**en ce que** la boucle de verrouillage de phase (60) comporte en outre un discriminateur de phase (31), et
**en ce que** le discriminateur de phase (31) compare un signal généré par la boucle de verrouillage de phase (60) à un signal dérivé de la fréquence de référence variable ($f_{ref}$).

**2.** Oscillateur haute fréquence selon la revendication 1, **caractérisé en ce que**
la boucle de verrouillage de phase (60) comporte exactement deux commutateurs (46, 47, 48, 49, 50, 51, 52, 53) par mélangeur (37, 38, 39, 40) à part un mélangeur (36), **en ce que** les commutateurs (46, 47, 48, 49, 50, 51, 52, 53) commutent le mélangeur respectif (37, 38, 39, 40) dans une première position de commutation dans la boucle de verrouillage de phase (60), et
**en ce que** les commutateurs (46, 47, 48, 49, 50, 51, 52, 53) shuntent le mélangeur respectif (37, 38, 39, 40) dans une seconde position de commutation.

**3.** Oscillateur haute fréquence selon la revendication 1 ou 2, **caractérisé en ce que**
le générateur de fréquence de référence (1) délivre la fréquence de référence variable ($f_{ref}$) au premier mélangeur (40) et le double de la fréquence de référence variable ($f_{ref}$) au second mélangeur (39).

**4.** Oscillateur haute fréquence selon l'une des revendications 1 à 3, **caractérisé en ce que**
la boucle de verrouillage de phase (60) comporte N mélangeurs (36, 37, 38, 39, 40), et
**en ce que** le générateur de fréquence de référence (1) délivre aux N mélangeurs (36, 37, 38, 39, 40) $N^2$ fois la fréquence de référence variable respective ($f_{ref}$).

**5.** Oscillateur haute fréquence selon l'une des revendications 1 à 4, **caractérisé en ce que**
la boucle de verrouillage de phase (60) comporte N mélangeurs (36, 37, 38, 39, 40),
**en ce que** la boucle de verrouillage de phase (60) comporte un multiplicateur de fréquence pour chacun des N mélangeurs (36, 37, 38, 39, 40),
**en ce que** le multiplicateur de fréquence respectif convertit la fréquence de référence variable ($f_{ref}$) en $N^2$ fois la fréquence de référence variable ($f_{ref}$) et la délivre au N-ième mélangeur (36, 37, 38, 39, 40).

**6.** Oscillateur haute fréquence selon l'une des revendications 1 à 5, **caractérisé en ce que**
les commutateurs (46, 47, 48, 49, 50, 51, 52, 53) de la boucle de verrouillage de phase (60) sont réalisés de sorte qu'au moins un mélangeur (36, 37, 38, 39, 40), de préférence au moins deux mélangeurs (36, 37, 38, 39, 40), sont toujours montés dans la boucle de verrouillage de phase (60).

7. Oscillateur haute fréquence selon l'une des revendications 1 à 6, **caractérisé en ce que**
le générateur haute fréquence (2) comporte en outre un oscillateur commandé en tension ou commandé en courant (33), de préférence un oscillateur Yttrium-Fer-Grenat (YIG),
**en ce que** la boucle de verrouillage de phase (60) délivre un signal de commande fine à l'oscillateur commandé (33),
**en ce que** le générateur haute fréquence (2) comporte en outre un dispositif de commande grossière (34), et
**en ce que** le dispositif de commande grossière (34) délivre un signal de commande grossière à l'oscillateur commandé (33).

8. Oscillateur haute fréquence selon l'une des revendications 1 à 7, **caractérisé en ce que**
le générateur haute fréquence (2) comporte en outre un diviseur fractionnel (30), et
**en ce que** le diviseur fractionnel (30) divise la fréquence du signal, qui est dérivé par la fréquence de référence variable ($f_{ref}$) générée par le générateur de fréquence de référence (1), par un facteur de division ($N_{Fmain}$).

9. Oscillateur haute fréquence selon l'une des revendications 1 à 8, **caractérisé en ce que**
le générateur haute fréquence (2) comporte en outre un répartiteur de puissance (35), et
**en ce que** le répartiteur de puissance (35) délivre une partie du signal haute fréquence ($f_{osz}$) de l'oscillateur commandé en tension (33) à la boucle de verrouillage de phase (60).

10. Oscillateur haute fréquence selon l'une des revendications 1 à 9, **caractérisé en ce que**
le générateur de fréquence de référence (1) comporte un oscillateur (14) contrôlé au moyen d'une boucle de verrouillage de phase (61) et un diviseur de fréquence (11),
**en ce que** le diviseur de fréquence (11) divise un signal de référence à fréquence fixe avec un facteur de division variable ($N_{Fref}$) et le délivre à la boucle de verrouillage de phase (61), et
**en ce que** la fréquence du signal haute fréquence ($f_{ref}$) de l'oscillateur réglé (11) peut être ajustée au moyen du facteur de division variable ($N_{Fref}$).

11. Oscillateur haute fréquence selon la revendication 10, **caractérisé en ce que**
le générateur de fréquence de référence (1) comporte au moins deux doubleurs de fréquence (15, 16, 17, 18) et au moins deux filtres passe bande (20, 21, 22, 23),
**en ce que** l'oscillateur réglé (14) est relié à un premier doubleur de fréquence (15),
**en ce qu'**un premier filtre passe bande (20) est relié au premier doubleur de fréquence (15),
**en ce que** le premier filtre passe bande (20) est en outre relié à un second doubleur de fréquence (16),
**en ce que** le second doubleur de fréquence (16) est relié à un second filtre passe bande (21),
**en ce que** le premier filtre passe bande (20) délivre le double de la fréquence de référence ($2*f_{ref}$), et
**en ce que** le second filtre passe bande (21) délivre le quadruple de la fréquence de référence ($4*f_{ref}$).

12. Oscillateur haute fréquence selon l'une des revendications 1 à 11, **caractérisé en ce que**
le générateur de fréquence de référence (1) comporte N doubleurs de fréquence montés en série (15, 16, 17, 18) et N filtres passe bande associés (20, 21, 22, 23), et
**en ce que** les N filtres passe bande (20, 21, 22, 23) délivrent respectivement N fois la fréquence de référence ($N*f_{ref}$).

Fig. 1

EP 2 664 068 B1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4105566 A1
- US 20090309665 A1